# EUROPEAN PATENT APPLICATION

(11) **EP 4 729 161 A1**
(43) Date of publication of application: **22.04.2026**
(21) Application number: 24851571.0
(22) Date of filing: 19.07.2024
(51) Int. Cl.: B01F 33/301, B01J 19/00, B81B 1/00

(54) **UNIFORM FLOW DIVIDING DEVICE AND FLUID SYSTEM**

(30) Priority: 07.08.2023 JP 2023128872
(71) Applicant: IMT Taiwan Co., Ltd., Hsinchu City, 30013 (TW); Institute Of Microchemical Technology Co., Ltd., Kawasaki-shi, Kanagawa 212-0032 (JP)
(72) Inventor: SANO Hiroki, Hsinchu City 30013 (TW); KITAMORI Takehiko, Hsinchu City 30013 (TW); KONISHI Katsunori, Hsinchu City 30013 (TW); MITOME Takahito, Hsinchu City 30013 (TW); LIN Yenchen, Hsinchu City 30013 (TW); CHEN Chihchen, Hsinchu City 30013 (TW); ENDO Yoshishige, Hsinchu City 30013 (TW)
(74) Representative: Scott, Stephen John
(86) International application number: PCT/JP2024/026045
(87) International publication number: WO 2025/033142

(57) **Abstract**

A uniform flow distribution device including a single substrate provided having flow channels connecting one inlet and a plurality of outlets. The flow channels include a flow distribution section configured to distribute a liquid introduced into the inlet of the substrate into a plurality of branch flow channels that connect to the outlets, and a flow resistance section that is located downstream of the flow distribution section and configured to provide flow resistance to each of the branch flow channels.

## Description

### CROSS-REFERENCE TO RELATED APPLICATION

The present application claims priority to and the benefit of Japanese Patent Application No. 2023-128872 filed August 7, 2023, the entire contents of which are incorporated herein by reference.

### TECHNICAL FIELD

The present disclosure relates to uniform flow distribution devices and fluidic systems.

### BACKGROUND

In recent years, microfluidic devices in which flow channels having widths on the order of micrometers are formed in a substrate, and fluidic systems using such devices to carry out liquid mixing, chemical reaction processes, and the like, have been proposed. Although the amount of liquid that can be processed by a single microfluidic device is small, the amount of liquid that can be processed can be increased by connecting multiple fluidic devices in parallel and carrying out parallel processing. However, flow resistance varies among fluidic devices due to individual differences. When fluidic devices having different flow resistances are connected in parallel, variations occur in the flow rate of liquid flowing through the fluidic devices. Therefore, when carrying out parallel processing using a plurality of fluidic devices, methods for making the flow rate of liquid supplied to each fluidic device uniform have been proposed (see, for example, Patent Literature (PTL) 1).

For example, according to PTL 1, connecting tubing that branches into multiple parts is connected to a liquid feed pump, and this branched tubing is connected to each of multiple fluidic devices arranged in parallel with each other using compensation tubes. The compensation tubes have a large flow resistance due to small inner diameter and/or long length. An object of PTL 1 is to uniformly distribute liquid to fluidic devices by setting the flow resistance of compensation tubes to be sufficiently larger than the flow resistance of downstream fluidic devices.

### CITATION LIST

### Patent Literature

PTL 1: JP 2006-263546 A

### SUMMARY

### (Technical Problem)

According to the method of PTL 1, variations in flow resistance may occur among individual branches of connecting tubing. Further, flow resistance may vary at a connection portion between connection tubing and a compensation tube. As a result, according to the method of PTL 1, the flow resistance of each flow channel varies greatly, making it difficult to precisely distribute liquid.

Accordingly, the present disclosure is made in view of the above, and it would be helpful to provide a uniform flow distribution device and a fluidic system that can distribute liquid to a plurality of fluidic devices with high precision.

### (Solution to Problem)

(1) A uniform flow distribution device according to an aspect of the present disclosure comprises a single substrate having flow channels connecting one inlet and a plurality of outlets, the flow channels including a flow distribution section configured to distribute a liquid introduced into the inlet of the substrate into a plurality of branch flow channels that connect to the outlets, and a flow resistance section that is located downstream of the flow distribution section and configured to provide flow resistance to each of the branch flow channels.
(2) The uniform flow distribution device according to (1) above, wherein the flow distribution section comprises one or more stages of branching sections that sequentially branch the flow channels into two at each stage.
(3) The uniform flow distribution device according to (1) or (2) above, wherein the flow distribution section comprises three stages of the branching sections, and the flow channels are branched into eight of the branch flow channels. By increasing the number of branching stages, the number of branches can be increased.
(4) The uniform flow distribution device according to any one of (1) to (3) above, wherein the flow distribution section has a shape that is symmetrical about an axis of symmetry that includes the inlet.
(5) The uniform flow distribution device according to any one of (1) to (4) above, wherein, in the flow resistance section, the branch flow channels have a coefficient of variation of flow resistance of less than 5 %.
(6) The uniform flow distribution device according to any one of (1) to (5) above, wherein, in the flow resistance section, the branch flow channels are formed to have the same shape.
(7) The uniform flow distribution device according to any one of (1) to (6) above, wherein, in the flow resistance section, the branch flow channels are formed to be smaller in at least one of width and depth than flow channels in the flow distribution section.
(8) The uniform flow distribution device according to any one of (1) to (7) above, wherein, in the flow resistance section, the branch flow channels are each formed as a flow channel that snakes back and forth in the substrate.
(9) The uniform flow distribution device according to any one of (1) to (8) above, wherein lengths of the branch flow channels are approximately equal to each other.
(10) The uniform flow distribution device according to any one of (1) to (9) above, wherein a difference between a maximum and a minimum of a flow rate of a liquid discharged from the outlets is 5 % or less of an average value of the flow rate.
(11) The uniform flow distribution device according to any one of (1) to (10) above, wherein the substrate is formed from a material that has chemical resistance.
(12) The uniform flow distribution device according to (11) above, wherein the material that has chemical resistance is glass, polyether ether ketone, ceramic, or metal.
(13) A fluidic system according to an aspect of the present disclosure includes a uniform flow distribution device, a liquid delivery mechanism, and a plurality of fluidic devices. The uniform flow distribution device comprises a single substrate having flow channels connecting one inlet and a plurality of outlets. The flow channels include a flow distribution section configured to distribute a liquid introduced into the inlet of the substrate into a plurality of branch flow channels that connect to the outlets, and a flow resistance section that is located downstream of the flow distribution section and configured to provide flow resistance to each of the branch flow channels. The liquid delivery mechanism is configured to deliver a liquid to the inlet of the uniform flow distribution device. The fluidic devices are configured to carry out operations on the liquid discharged from each of the outlets of the uniform flow distribution device.
(14) The fluidic system according to (13) above, wherein a pressure drop due to the flow resistance of any of the branch flow channels of the flow resistance section is greater than a pressure drop due to the flow resistance of the fluidic device located downstream of the branch flow channel.
(15) The fluidic system according to (13) or (14) above, wherein an average value of the flow resistance of the branch flow channels of the flow resistance section is greater than an average value of the flow resistance of the fluidic devices.
(16) The fluidic system according to any one of (13) to (15) above, wherein an average value of the flow resistance of the branch flow channels of the flow resistance section is ten times or more greater than an average value of the flow resistance of the fluidic devices.

### (Advantageous Effect)

According to the uniform flow distribution device and the fluidic system of the present disclosure, the single substrate of the uniform flow distribution device includes the flow distribution section configured to distribute liquid into the plurality of branch flow channels and the flow resistance section that imparts flow resistance to the branch flow channels, thereby enabling liquid to be distributed precisely to a plurality of fluidic devices.

### BRIEF DESCRIPTION OF THE DRAWINGS

In the accompanying drawings:
FIG. 1 is a schematic diagram illustrating an example of a fluidic system according to an embodiment;
FIG. 2 is a plan view diagram illustrating an example of the uniform flow distribution device of FIG. 1;
FIG. 3 is a plan view diagram illustrating an example of the fluidic device of FIG. 1;
FIG. 4 is a diagram illustrating a configuration of an evaluation apparatus for uniform flow distribution devices according to tested examples; and
FIG. 5A to FIG. 5F are diagrams illustrating examples of evaluation results of the uniform flow distribution devices according to tested examples.

### DETAILED DESCRIPTION

Embodiments of the present disclosure are described below with reference to the drawings.

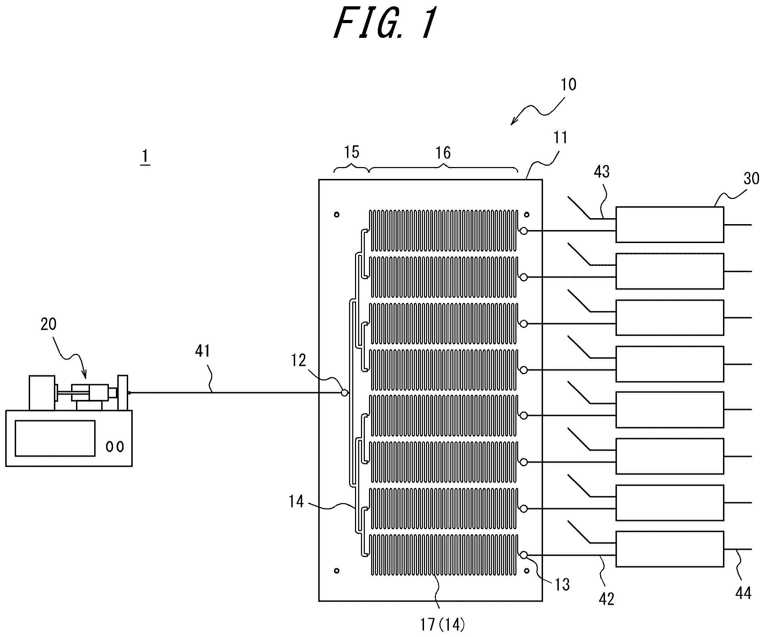

As illustrated in FIG. 1, a fluidic system 1 according to an embodiment of the present disclosure includes a uniform flow distribution device 10, a liquid feed pump 20 that is a liquid delivery mechanism, and a plurality of fluidic devices 30. Each of the fluidic devices 30 may be a microfluidic device having minute flow channels each having a flow channel width of up to about 500 µm (micrometers). The fluidic system 1 may be a microfluidic system including microfluidic devices.

The fluidic devices 30 that are microfluidic devices can carry out operations such as mixing and/or reactions between liquids. The fluidic devices 30 have various advantages that could not be obtained in conventional fluidic devices having a flow channel width of several mm (millimeters) or more. For example, in a mixing operation, it is known that when the flow channel width is reduced to 1/10 of that of conventional technology, mixing time is reduced to about 1/100. Accordingly, an operation that would have taken an hour with conventional technology can be completed in less than one minute. Further, in a reaction operation, the reaction is completed instantly, suppressing production of byproducts and significantly improving reaction yield.

The fluidic system 1 distributes the liquid supplied from the liquid feed pump 20 with high precision so that the liquid becomes approximately uniform using the uniform flow distribution device 10, and supplies the liquid to the plurality of the fluidic devices 30 connected in parallel to the uniform flow distribution device 10. The plurality of the fluidic devices 30 are devices that carry out the same operation on the same liquid. However, individual fluidic devices 30 often have different flow resistances due to large individual differences caused by dimensional tolerances in height, width, and length of flow channels. Unlike the present embodiment, when liquid supplied from the same liquid delivery mechanism is connected to a plurality of the fluidic devices 30 via a plurality of branched tubes, a flow rate of liquid supplied to each of the fluidic devices 30 may become uneven due to differences in the flow resistance of the fluidic devices 30. Specifically, liquid flows more to a flow channel that has a lower flow resistance. When the liquid flowing through the fluidic devices 30 is not at equivalent flow rates, reaction efficiency in the fluidic devices 30 may decrease.

Therefore, the uniform flow distribution device 10 according to the present embodiment is configured to precisely distribute liquid to be approximately uniform, using flow channels 14 formed on the same substrate, and to have a flow resistance that is higher than the flow resistance of the fluidic devices 30. The configuration of each section of the fluidic system 1 is described below.

Flow resistance is a force that occurs in the opposite direction to flow of a fluid when the fluid is forced to flow along a flow channel. In microfluidic devices, the fine flow channel structure tends to increase flow resistance. A loss of energy due to flow resistance is called pressure drop. In a fluid, pressure drop causes downstream pressure to be lower than upstream pressure.

### (Uniform flow distribution device)

The uniform flow distribution device 10 comprises a single substrate 11. The substrate 11 has the flow channels 14 formed therein, which connect one inlet 12 with a plurality of outlets 13. The flow channels 14 have an upstream side and a downstream side defined based on a flow direction of a liquid supplied from the liquid feed pump 20. When viewed from the uniform flow distribution device 10, the liquid feed pump 20 side is the upstream side, and the fluidic device 30 side is the downstream side.

The substrate 11 is a rectangular plate-like member in plan view. However, the shape of the substrate 11 is not limited to this example. The size of the substrate 11 may be set arbitrarily. For example, the size of the substrate 11 may be on the order of some cm (centimeters) to some tens of cm in plan view. Further, thickness of the substrate 11 may be on the order of some mm to some cm. Further, the substrate 11 is made of a material that has chemical resistance. Examples of materials that have chemical resistance include, but are not limited to, glass or polyether ether ketone (PEEK) material. As the material that has chemical resistance, ceramic or metal may be used.

The inlet 12 is an opening that receives fluid supplied to the uniform flow distribution device 10 from outside. The inlet 12 is located at the upstream end of the flow channels 14. The inlet 12 may be located on one of the widest surfaces of the substrate 11, for example, on the top surface. The inlet 12 is connected to the liquid feed pump 20 via a tube 41. A connection portion between the liquid feed pump 20 and the tube 41 and a connection portion between the tube 41 and the inlet 12 are tightly sealed to prevent leakage of liquid. The same applies to connection portions between other tubes 42, 43, 44 and any devices described below. The tube 41 transports the liquid supplied from the liquid feed pump 20 to the inlet 12. The tube 41 and the tubes 42, 43, 44 described below may be made of PEEK resin from the viewpoint of chemical resistance, heat resistance, pressure resistance, and the like.

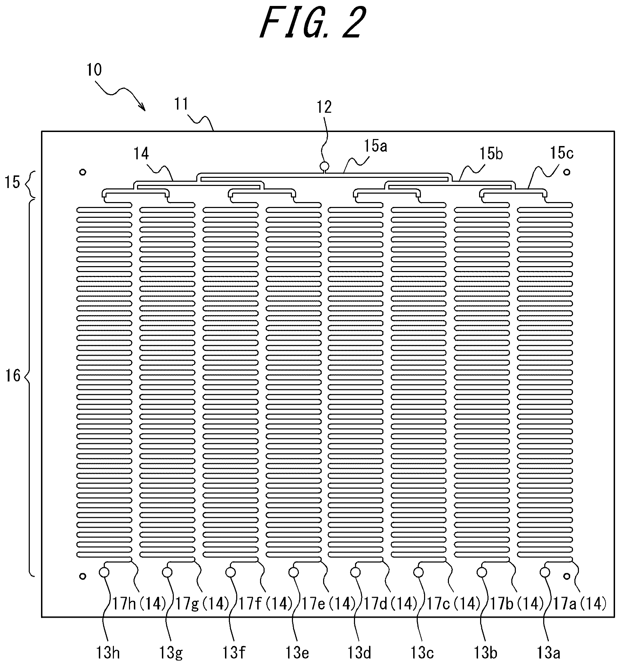

The outlets 13 are openings for discharging fluid that has flowed through the flow channels 14 of the uniform flow distribution device 10 to outside the uniform flow distribution device 10. The outlets 13 are located at the downstream ends of respective branch flow channels 17. The outlets 13 may be arranged on one of the widest surfaces of the substrate 11, for example, on the top surface. In the example illustrated in FIG. 1 and FIG. 2, the number of the outlets 13 is eight, but the number of the outlets 13 is not limited to this example. Each of the outlets 13 is connected to one of the fluidic devices 30 by one of the tubes 42.

The flow channels 14 are, for example, minute micro-flow channels each having a flow channel width on the order of µm. However, the width of the flow channels 14 is not limited to this range. The flow channels 14 allow a fluid to pass from the upstream side to the downstream side. The flow channels 14 can be formed in the substrate 11 using a known technique. For example, the flow channels 14 may be formed by making the substrate 11 a two-layer structure, forming an open groove that will become the flow channels 14 in the first layer of the substrate, and then joining the second layer of the substrate so as to close the open groove.

The flow channels 14 include a flow distribution section 15 and a flow resistance section 16 located downstream of the flow distribution section 15.

In the flow distribution section 15, the flow channels 14 precisely distribute the liquid introduced into the inlet 12 of the substrate 11 into a plurality of the branch flow channels 17 connected to the outlets 13 so that the liquid is distributed uniformly. The branch flow channels 17 are a portion of the flow channels 14. The flow distribution section 15 is configured to include one or more branching sections 15a, 15b, 15c that each evenly branch the flow channels 14 into two flow channels.

The flow distribution section 15 may include one or more of the branching sections 15a, 15b, 15c that each sequentially branch the flow channels 14 into two at each stage. At each stage, the flow distribution section 15 further evenly branches the flow channels 14 branched at an upper stage into two flow channels. When viewed from a direction perpendicular to the substrate 11, that is, in plan view, the flow distribution section 15 may have a shape that is symmetrical about an axis of symmetry that includes the inlet 12 and extends toward the flow resistance section.

For example, in the example of FIG. 1 and FIG. 2, the flow distribution section 15 includes three stages of branching sections 15a, 15b, 15c, and branches a flow channel 14 into eight branch flow channels 17a to 17h. The branch flow channels 17a to 17h are individual branch flow channels 17 included in the plurality of the branch flow channels 17. The first stage branching section 15a is disposed upstream and closest to the inlet 12. The first stage branching section 15a evenly branches the flow channel 14 connected to the inlet 12 into two flow channels 14. A second stage branching section 15b is disposed in each flow channel 14 downstream of the first stage branching section 15a. The second stage branching section 15b evenly branches each of the two flow channels 14 branched at the first stage branching section 15a into two flow channels 14. That is, the flow channel 14 is evenly branched into a total of four by the two second stage branching sections 15b. The third stage branching section 15c evenly branches each of the four flow channels branched at the second stage branching section 15b into two flow channels 14. That is, the flow channel 14 is evenly branched into a total of eight branch flow channels 17a to 17h by the four third stage branching sections 15c. Here, each of the branching sections 15a, 15b, and 15c branches the upstream flow channel 14 into downstream flow channels 14 that are arranged symmetrically and have substantially the same shape. Hereinafter, "evenly branching" the flow channel means that the liquid flowing through the branching sections 15a, 15b, 15c is uniformly distributed within a range that takes into account manufacturing errors and the like, under the condition that the flow resistances on the downstream side are equal. Further, "uniformly distributing" a liquid means distributing the liquid into equal amounts. That is, even when the branching sections 15a, 15b, 15c branch the flow channels 14 evenly, the liquid may not be distributed uniformly due to the flow resistance on the downstream side.

For example, when a branching section branches a flow channel 14 into three, the branched central flow channel and the flow channels on both sides are not in symmetrical positions, and therefore it is difficult to branch the flow channel so as to make the flow rates uniform. To address this, the branching sections 15a, 15b, 15c each branch the flow channel 14 into two, so that the two flow channels after branching can be arranged symmetrically to each other. Therefore, when the flow resistance on the downstream side is the same, the liquid can be distributed uniformly with high precision. In the uniform flow distribution device 10 of the present disclosure, the branching sections 15a, 15b, 15c that evenly branch the flow channel into two are arranged in one or more stages, so that the flow channel 14 can be accurately branched evenly into the branch flow channels 17.

The flow resistance section 16 is located downstream of the flow distribution section 15 and provides flow resistance to each of the branch flow channels 17. The flow resistance of each of the branch flow channels 17 in the flow resistance section 16 is 10 or more times or 100 or more times greater than the flow resistance from the inlet 12 to the branch flow channels 17 branched by the flow distribution section 15. This makes it possible to reduce the effect on the flow rate of each branch flow channel 17 even when nonuniformity occurs between the flow channels 14 branched by the flow distribution section 15.

The flow resistance section 16 can be configured so that the pressure drop of the liquid flowing within the fluidic system 1 due to the flow resistance of any one branch flow channel 17 is greater than the pressure drop of the liquid due to the flow resistance of the fluidic device 30 located downstream of the branch flow channel 17. The pressure drop due to the flow resistance of the branch flow channel 17 may be ten times or more the pressure drop due to the flow resistance of the fluidic device 30.

Further, an average value of the flow resistance of the branch flow channels 17 of the flow resistance section 16 is greater than an average value of the flow resistance of the fluidic devices 30 to which the branch flow channels 17 are connected. For example, the average value of the flow resistance of the branch flow channels 17 of the flow resistance section 16 may be ten times or more the average value of the flow resistance of the fluidic devices 30 to which the branch flow channels 17 are connected. Further, the flow resistance of each branch flow channel 17 of the flow resistance section 16 may be greater than the flow resistance of the fluidic device 30 to which the branch flow channel 17 is connected. For example, the flow resistance of each branch flow channel 17 of the flow resistance section 16 may be ten times or more the flow resistance of the individual fluidic device 30 to which the branch flow channel 17 is connected. Further, an average value of pressure drop in the flow resistance section 16 for liquid passing through the branch flow channels 17 may be equal to or greater than or ten times or more than the average value of pressure drop in the fluidic devices 30 for liquid passing through the fluidic devices 30.

In order to increase the flow resistance, the branch flow channels 17 in the flow resistance section 16 may be formed to be smaller in at least one of width and depth than the flow channels 14 in the flow distribution section 15. Further, in order to increase the flow resistance, in the flow resistance section 16, the branch flow channels 17 may be formed as flow channels that snake back and forth through defined regions assigned to each branch flow channel 17 within the substrate 11. As a result, the length of the branch flow channels 17 becomes longer, and the flow resistance increases due to the inclusion of bends in the flow channel.

The branch flow channels 17 are configured so that the flow resistances are approximately equal to each other. Therefore, the branch flow channels 17 may be formed to have approximately the same shape. Further, the lengths of the branch flow channels 17 may be approximately equal to each other, excluding a margin of error. The plurality of the branch flow channels 17 preferably has a coefficient of variation of flow resistance of less than 5 %. The coefficient of variation of flow resistance is a value obtained by dividing deviation values of the flow resistance of all the branch flow channels 17 by the average value. When the coefficient of variation of flow resistance is less than 5 %, the flow resistances of the branch flow channels 17 can be considered to be approximately equal to each other.

### (Liquid feed pump)

The liquid feed pump 20 is a device that supplies a liquid that is a raw material for a chemical reaction in the fluidic devices 30 to the uniform flow distribution device 10 via the tube 41. The liquid feed pump 20 supplies the liquid stored in a raw material tank or the like to the tube 41. The liquid feed pump 20 is, for example, a syringe pump or a diaphragm pump, but is not limited to these examples. Other types of pumps may also be used as the liquid feed pump 20.

### (Fluidic device)

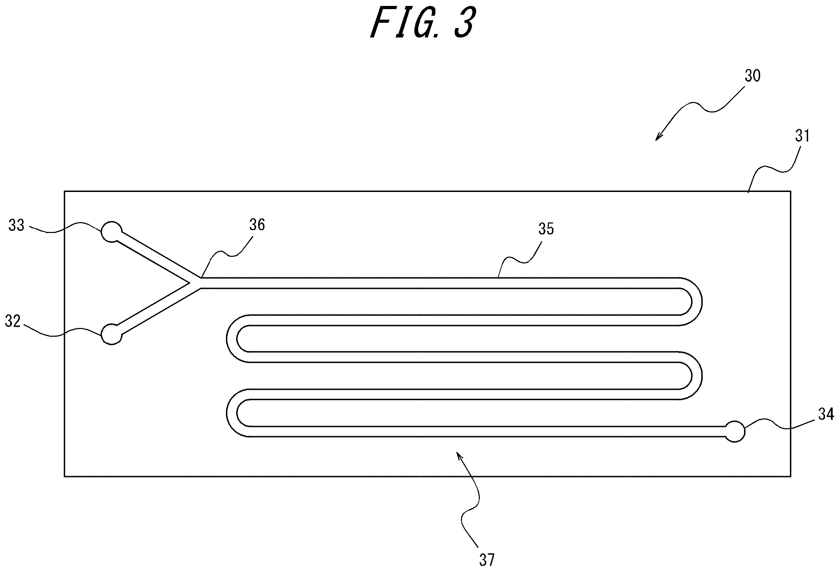

As illustrated in FIG. 3, the fluidic device 30 includes a substrate 31. As an example, the substrate 31 is formed having flow channels 35 that connects a first inlet 32 and a second inlet 33 to an outlet 34.

The first inlet 32 is connected to a corresponding outlet 13 of the uniform flow distribution device 10 via a tube 42. The tube 42 transports liquid discharged from the outlet 13 of the uniform flow distribution device 10 to the first inlet 32. The first inlet 32 receives liquid distributed by the uniform flow distribution device 10.

The second inlet 33 is connected to another liquid delivery mechanism or another fluidic device via a tube 43. The tube 43 supplies liquid from the other liquid delivery mechanism or the other fluidic device to the fluidic device 30 for mixing and chemical reaction with the liquid supplied from the liquid feed pump 20.

The flow channels 35 connected to the first inlet 32 and the second inlet 33 merge at a merging portion 36 downstream of the first inlet 32 and the second inlet 33. A mixing/reaction flow channel 37 is disposed downstream of the merging portion 36 so as to snake back and forth within the substrate 31 multiple times. The liquid introduced from the first inlet 32 and the liquid introduced from the second inlet 33 are mixed as they flow through the mixing/reaction flow channel 37, which is part of the flow channels 35, and a chemical reaction occurs due to reactants contained in each liquid.

Liquid containing a product produced as a result of the chemical reaction in the mixing/reaction flow channel 37 is discharged from the outlet 34 into a tube 44. As illustrated in FIG. 1, by arranging a plurality of the fluidic devices 30 in parallel, a yield of the product can be increased in accordance with the number of the fluidic devices 30.

With the above-described configuration, the uniform flow distribution device 10 according to the present embodiment has the flow distribution section 15 and the flow resistance section 16 arranged on the same substrate 11. This makes it possible to suppress variation in flow resistance compared to when the flow distribution section 15 and the flow resistance section 16 are separate components and connected using a connector, tube for liquid transport, or the like, which are likely to cause variation in flow resistance. Further, by configuring the flow distribution section 15 to have one or more stages of the branching sections 15a, 15b, 15c that evenly branch the flow channels 14 into two, the uniform flow distribution device 10 is able to distribute the liquid even more uniformly.

Further, in the fluidic system 1 according to the present embodiment, the flow resistances of the flow resistance section 16 of the uniform flow distribution device 10 are approximately equal to each other, and the average value is greater than the average value of the flow resistances of the fluidic devices 30. Therefore, even when there are individual differences in the flow resistance of individual fluidic devices 30, the ratio of variation in the overall flow resistance can be suppressed. As a result, the flow rates of the liquid supplied to each fluidic device 30 can be made closer to a uniform flow rate.

In particular, by making the average value of flow resistance of the branch flow channels 17 of the flow resistance section 16 ten times or more greater than the average value of flow resistance of the fluidic devices 30, the flow rate of the liquid flowing through the fluidic devices 30 becomes more uniform. Further, in the flow resistance section 16, when the coefficient of variation of the flow resistances of the branch flow channels 17 is less than 5 %, the impact of variation in the flow resistance of the flow resistance section 16 on variations in the flow rate of the liquid supplied to the fluidic devices 30 can be kept low.

### EXAMPLES

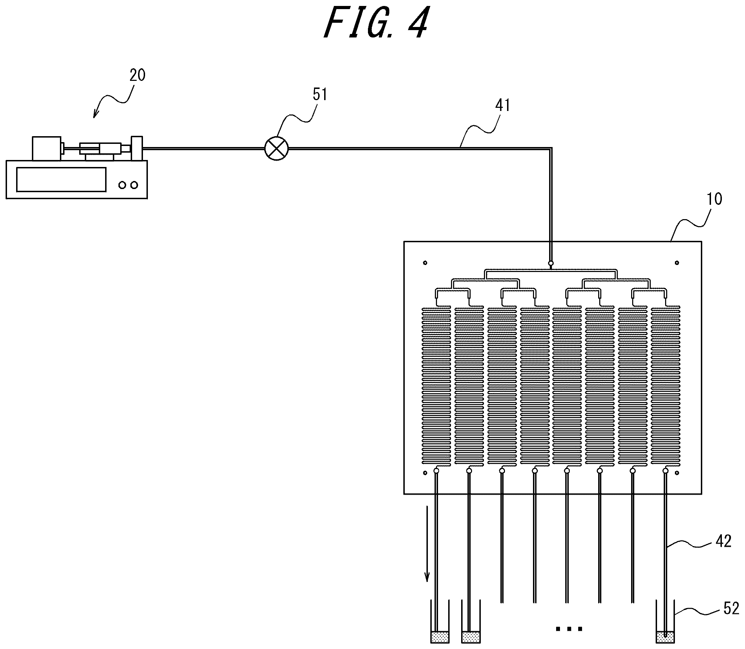

The inventors have verified the flow distribution performance of the uniform flow distribution device 10 using the apparatus configuration illustrated in FIG. 4. Although some reference signs are omitted in FIG. 4, the following description uses the reference signs assigned in FIG. 1 to FIG. 3 as appropriate. In the uniform flow distribution device 10, borosilicate glass having a thickness of 1.4 mm was used as the substrate 11. Further, the flow channels 14 in the flow distribution section 15 each had a width of 0.5 mm and a depth of 0.5 mm, and were configured to branch into eight as in the examples of FIG. 1 and FIG. 2. Further, the branch flow channels 17 of the flow resistance section 16 each had a width of 0.1 mm, a depth of 0.03 mm, and a length of 50 mm.

An isopropyl alcohol (IPA) solution was fed from the liquid feed pump 20 to the uniform flow distribution device 10 at a flow rate of 60 µL/min. The flow rate of the IPA solution discharged from each outlet 13 into a recovery container 52 after passing through the flow resistance section 16 was measured by a precision balance. A pressure sensor 51 for measuring the pressure inside the tube 41 was provided midway along the tube 41. The pressure sensor 51 was used to detect abnormalities such as leaks, air bubbles, or blockages.

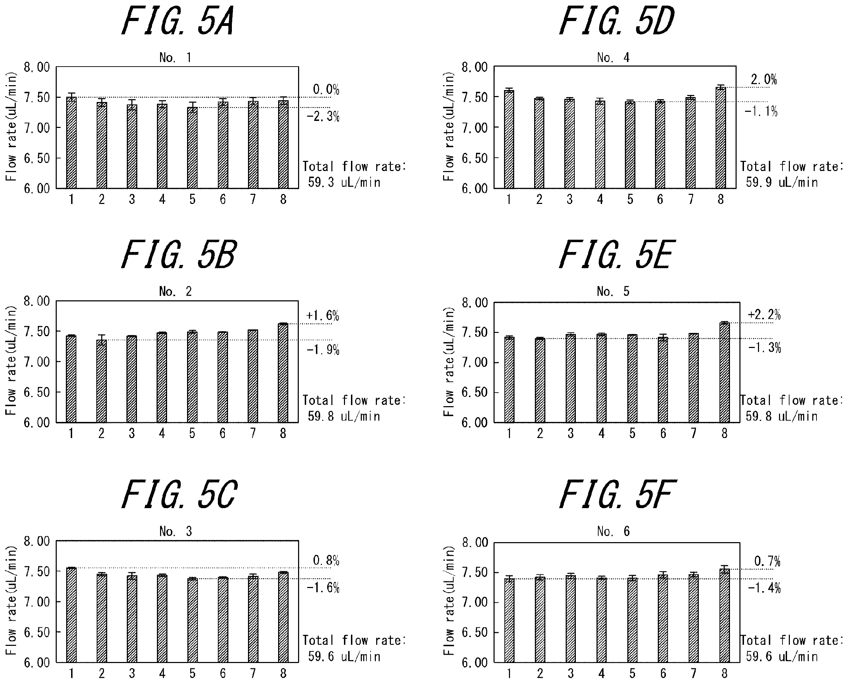

FIG. 5A to FIG. 5F illustrate the results of measurements carried out six times in total for different uniform flow distribution devices 10. The eight bars in each of FIG. 5A to FIG. 5F illustrate the flow rates of solutions ejected from the eight outlets 13, respectively. On the right side of each graph, the difference from 7.50 µL/min is shown as a percentage. 7.50 µL/min is a value obtained by dividing the flow rate of 60 µL/min of the liquid feed pump 20 into eight equal parts. In this way, the ratio of the difference between the flow rate of the actually distributed liquid and the flow rate that would be obtained if the liquid before the distribution were uniformly distributed is called liquid transport precision. In all of the cases illustrated in FIG. 5A to FIG. 5F, the liquid transport precision was less than ±2.5 %. In this way, when the difference between the maximum and minimum flow rates of the liquid discharged from the outlets 13 is 5 % or less of the average value of flow rate, it can be said that the liquid transport precision is high.

The above measurement was carried out in a state where the fluidic devices 30 were not connected downstream. However, even if the fluidic devices 30 were further connected to the outlets 13, as long as the flow resistance of the fluidic devices 30 is smaller than the flow resistance of the flow resistance section 16, the effect on the total flow resistance of each flow channel branched by the uniform flow distribution device 10 would be relatively small. For example, assume that the average value of the flow resistance of the flow resistance section 16 is ten times the average value of the flow resistance of the fluidic device 30. Even if a 30 % variation occurs in the flow resistance of the fluidic devices 30, when viewed from the overall flow resistance of each flow channel after branching at the flow distribution section 15, the variation would only be about 3 %.

The inventors carried out similar measurements without using the uniform flow distribution device 10, by connecting tubing that branched into eight to the liquid feed pump 20 as in conventional technology, and connecting a thin-diameter tube having an inner diameter of 0.05 mm and a length of 50 cm to each of the branched tubes. As a result, the liquid transport precision was ±10 % to ±20 %. Further, the liquid transport precision changed each time the device was assembled, and therefore it is thought that errors caused by human factors had a large impact. The most influential human factor is thought to be deformation of a tube cross-section that occurs when cutting a thin tube. When a small diameter tube is cut with a cutter or the like, the cross-section of the tube may be plastically deformed, resulting in a reduction in cross-section area. Further, when the thin tube is not cut perpendicular to the central axis, an end face of the tube will not come into uniform contact with a device or sealing material, which may cause the tip of the tube to deform and block part of the flow channel.

Accordingly, the uniform flow distribution device 10 used in these tested examples has higher liquid transport precision than conventional technology. This is because the flow distribution section 15 and the flow resistance section 16 are provided on the same substrate 11. When the uniform flow distribution device 10 of the tested examples is applied to the fluidic system 1, it becomes possible to deliver liquid to the fluidic devices 30 at a more uniform flow rate than according to conventional technology.

The present disclosure is not limited to the above-described embodiments, and can be varied or modified in many ways. The configurations of the uniform flow distribution device 10, the fluidic devices 30, and the fluidic system 1 in the above-described embodiments are merely examples. Addition, omission, substitution, and other modifications of configuration are possible as appropriate within the scope of the present disclosure.

The fluidic devices 30 of the present disclosure have been described as microfluidic devices each having a flow channel width on the order of µm. However, the dimensions of the flow channels of the fluidic devices 30 of the present disclosure are not limited to this. The fluidic devices 30 may include a flow channel having a width of 1 mm or more, and may include a flow channel having a width of less than 1 µm.

For example, according to an above embodiment, the flow distribution section 15 of the uniform flow distribution device 10 branches the flow channel 14 in three stages. However, the flow distribution section 15 may branch the flow channel in one stage, two stages, or four or more stages. By increasing the number of branching stages, the number of branches can be increased. The shapes and arrangements of the flow channels 14 of the flow distribution section 15 and flow resistance section 16 of the uniform flow distribution device 10 illustrated in FIG. 1 and FIG. 2 are merely examples. The uniform flow distribution device 10 can be fabricated with a variety of flow channel configurations. Further, according to an above embodiment, the inlet 12 and the outlets 13 are disposed on the upper surface of the substrate 11. However, arrangement of the inlet 12 and the outlets 13 is not limited to this. The inlet 12 and the outlets 13 may be arranged on side surfaces of the substrate 11, for example.

According to an above embodiment, the fluidic devices 30 carry out operations such as mixing of liquids and chemical reactions. However, the operations carried out by the fluidic devices 30 are not limited to these examples. The operations carried out by the fluidic device 30 may include liquid-phase mixing, liquid-phase reaction, gas-liquid mixing, gas-liquid reaction, extraction, distillation, concentration, slurry mixing, solid-phase extraction, particle separation/liquid separation, crystallization, cell culturing, and the like. Further, the fluid passing through the flow channels of the uniform flow distribution device 10 and the fluidic devices 30 is not limited to liquids and may include gases.

### REFERENCE SIGNS LIST

- 1: fluidic system
- 10: uniform flow distribution device
- 11: substrate
- 12: inlet
- 13,13a to 13h: outlet
- 14: flow channel
- 15: flow distribution section
- 15a: first stage branching section
- 15b: second stage branching section
- 15c: third stage branching section
- 16: flow resistance section
- 17, 17a to 17h: branch flow channel
- 20: liquid feed pump (liquid delivery mechanism)
- 30: fluidic device
- 31: substrate
- 32: first inlet
- 33: second inlet
- 34: outlet
- 35: flow channel
- 36: merging portion
- 37: mixing/reaction flow channel
- 41 to 44: tube
- 51: pressure sensor
- 52: recovery container

## Claims

1. A uniform flow distribution device comprising:
a single substrate having flow channels connecting one inlet and a plurality of outlets;
the flow channels including
a flow distribution section configured to distribute a liquid introduced into the inlet of the substrate into a plurality of branch flow channels that connect to the outlets, and
a flow resistance section that is located downstream of the flow distribution section and configured to provide flow resistance to each of the branch flow channels.

2. The uniform flow distribution device according to claim 1, wherein the flow distribution section comprises one or more stages of branching sections that sequentially branch the flow channels into two at each stage.

3. The uniform flow distribution device according to claim 2, wherein the flow distribution section comprises three stages of the branching sections, and the flow channels are branched into eight of the branch flow channels.

4. The uniform flow distribution device according to claim 1, wherein the flow distribution section has a shape that is symmetrical about an axis of symmetry that includes the inlet.

5. The uniform flow distribution device according to claim 1, wherein, in the flow resistance section, the branch flow channels have a coefficient of variation of flow resistance of less than 5 %.

6. The uniform flow distribution device according to claim 1, wherein, in the flow resistance section, the branch flow channels are formed to have the same shape.

7. The uniform flow distribution device according to claim 1, wherein, in the flow resistance section, the branch flow channels are formed to be smaller in at least one of width and depth than flow channels in the flow distribution section.

8. The uniform flow distribution device according to claim 1, wherein, in the flow resistance section, the branch flow channels are each formed as a flow channel that snakes back and forth in the substrate.

9. The uniform flow distribution device according to claim 1, wherein lengths of the branch flow channels are approximately equal to each other.

10. The uniform flow distribution device according to claim 1, wherein a difference between a maximum and a minimum of a flow rate of a liquid discharged from the outlets is 5 % or less of an average value of the flow rate.

11. The uniform flow distribution device according to claim 1, wherein the substrate is formed from a material that has chemical resistance.

12. The uniform flow distribution device of claim 11, wherein the material that has chemical resistance is glass, polyether ether ketone, ceramic, or metal.

13. A fluidic system comprising:
a uniform flow distribution device comprising a single substrate having flow channels connecting one inlet and a plurality of outlets, the flow channels including a flow distribution section configured to distribute a liquid introduced into the inlet of the substrate into a plurality of branch flow channels that connect to the outlets, and a flow resistance section that is located downstream of the flow distribution section and configured to provide flow resistance to each of the branch flow channels;
a liquid delivery mechanism configured to deliver a liquid to the inlet of the uniform flow distribution device; and
a plurality of fluidic devices configured to carry out operations on the liquid discharged from each of the outlets of the uniform flow distribution device.

14. The fluidic system according to claim 13, wherein a pressure drop due to the flow resistance of any of the branch flow channels of the flow resistance section is greater than a pressure drop due to the flow resistance of the fluidic device located downstream of the branch flow channel.

15. The fluidic system according to claim 13, wherein an average value of the flow resistance of the branch flow channels of the flow resistance section is greater than an average value of the flow resistance of the fluidic devices.

16. The fluidic system according to claim 13, wherein an average value of the flow resistance of the branch flow channels of the flow resistance section is ten times or more greater than an average value of the flow resistance of the fluidic devices.
